# EUROPEAN PATENT APPLICATION

(11) **EP 0 547 890 A2**
(43) Date of publication of application: **23.06.1993**
(21) Application number: 92311512.5
(22) Date of filing: 16.12.1992
(51) Int. Cl.: G11C 7/00

(54) **A read/write memory with interlocked write control**

(30) Priority: 17.12.1991 US 809391
(71) Applicant: SGS-THOMSON MICROELECTRONICS, INC., Carrollton Texas 75006 (US)
(72) Inventor: Iyengar, Narasimhan, Plano, Texas 75093 (US)
(74) Representative: Palmer, Roger

(57) **Abstract**

A read/write memory, such as a static random access memory, is disclosed in which equilibration of differential data lines, such as bit lines or input/output lines, is performed at the beginning of each cycle. The memory includes a write circuit, for example associated with each sense amplifier, for driving the differential data lines with a data state corresponding to input data during a write operation. The write circuit is controlled by a write enable signal which, in this memory, is interlocked with the equilibration signal. As a result, the write operation is disabled during equilibration of the differential data lines. Since equilibration is maintained during address transitions, the write operation is only enabled during stable address periods, thus eliminating the possibility of a write to the address of a prior or subsequent cycle.

## Description

This invention is in the field of integrated circuits, and is more specifically directed to the writing of data into integrated circuit memories.

In the field of integrated circuit memories, the speed by which memory accesses are performed is of course a critical parameter. The importance of memory performance has become even more critical as the speed at which computer systems operate has drastically increased in recent years, with 33 MHz personal computers now readily available. Such high speed computer systems now utilize high speed static random access memories (SRAMs) as their main memory, such SRAMs having specified cycle times, and read access times, of less than 20 nsec.

While the read access time is of course an important parameter in such memories, the ability to accurately perform a write operation to a selected memory cell in the SRAM device within the specified cycle time is also essential for adequate system performance. The receipt and internal communication of input data is a significant factor in the design of such memories. In addition, the timing of the various control signals within the memory is also quite critical, as the input data must of course be applied to the correct memory cell.

Most conventional integrated circuits generate an internal write control signal, which must be energized at the appropriate times in the memory cycle relative to other internal operations. If, for example, the internal write signal is energized faster than the decoding of the address, the input data can be written to the wrong memory location (i.e., the memory location accessed in the prior cycle). Conventional memory designs thus slow down the generation of the leading edge of the write signal, for example by way of gate delays, to ensure that it is not activated until sufficient time has elapsed to effect address decoding.

In addition, the termination of the write operation must also be closely controlled so that it occurs prior to the next cycle's operations; if the internal write signal is terminated too late, after the decoding of the next address, data will be written into the wrong location (i.e., the location accessed in the next cycle). For example, in conventional SRAMs the timing of ATD signals and also the internal address propagation are generally selected by making tradeoffs between read cycle timing and write cycle timing. Specifically, it is desirable in read cycles that the internal address signals propagate as rapidly as possible in order to minimize the read access time. However, rapid propagation of the address signals may cause the new address to reach a portion of the chip ahead of the signal terminating the write operation, especially in long memory chips, which would cause the prior cycle's write to affect the new address. In the design of memories, therefore, propagation of the internal address signals may be slowed from the maximum speed (and the read performance slowed accordingly) so that write errors do not result.

The above combination thus requires that the leading edge of the write signal be delayed from the initiation of the address value, but that the trailing edge of the write signal be in advance of its next transition. This timing relationship is conventionally been accomplished by way of gate delays. In modern high speed, high density memories, though, both the high speed and the long distances over which these internal signals must propagate increases the risk of internal race conditions for signals having their internal timing controlled by designed gate delays. The possibility of race conditions is exacerbated by the receipt of address inputs at different parts of the large chips, often necessitating slowing down of the write sequence to avoid such race conditions.

The difficulty of accurately controlling internal write operations, using gate delays, is further exacerbated in SRAMs for which cycles are initiated by the detection of address transition detection. This is because a new cycle can be initiated at any time, and also because the address transitions can occur at the various address input terminals in an asynchronous manner, resulting in long periods of instability.

It is therefore an object of the present invention to provide control of internal write operations without relying on relative gate delays.

It is a further object of the present invention to provide such control without requiring additional cycle time to do so.

It is a further object of the present invention to provide such write control in a relatively simple manner.

It is a further object of the present invention to provide such write control in memories which are subject to unstable inputs, such as address values, applied thereto.

It is a further object of the present invention to allow the timing internal address signals and address transition detection signals to be optimized for the read operation, without risk of write errors, thus improving read access time performance.

Other objects and advantages will be apparent to those of ordinary skill in the art having reference to the following description together with the drawings.

The invention may be incorporated into an integrated circuit memory, such as a static random access memory (SRAM), in which differential bit lines and data lines are equilibrated. The write drivers are interlocked with an equilibration signal, so that no write can occur during equilibration. Since equilibration occurs during such time as the address inputs are unstable, the interlock ensures that no write operation is enabled over an address transition period, and ensures accurate and high performance write operations.

Some embodiments of the invention will now be described by way of example and with reference to the accompanying drawings in which:
Figure 1 is an electrical diagram, in block form, of a memory according to the preferred embodiment of the invention.
Figure 2 is an electrical diagram, in schematic form, of a typical column in the memory of Figure 1.
Figure 3 is an electrical diagram, in schematic form, of a sense amplifierand write circuit in the memory of Figure 1.
Figure 4 is an electrical diagram, in schematic and block form, of a portion of the timing and control circuitry in the memory of Figure 1.
Figure 5 is a timing diagram illustrating the operation of the preferred embodiment of the invention.

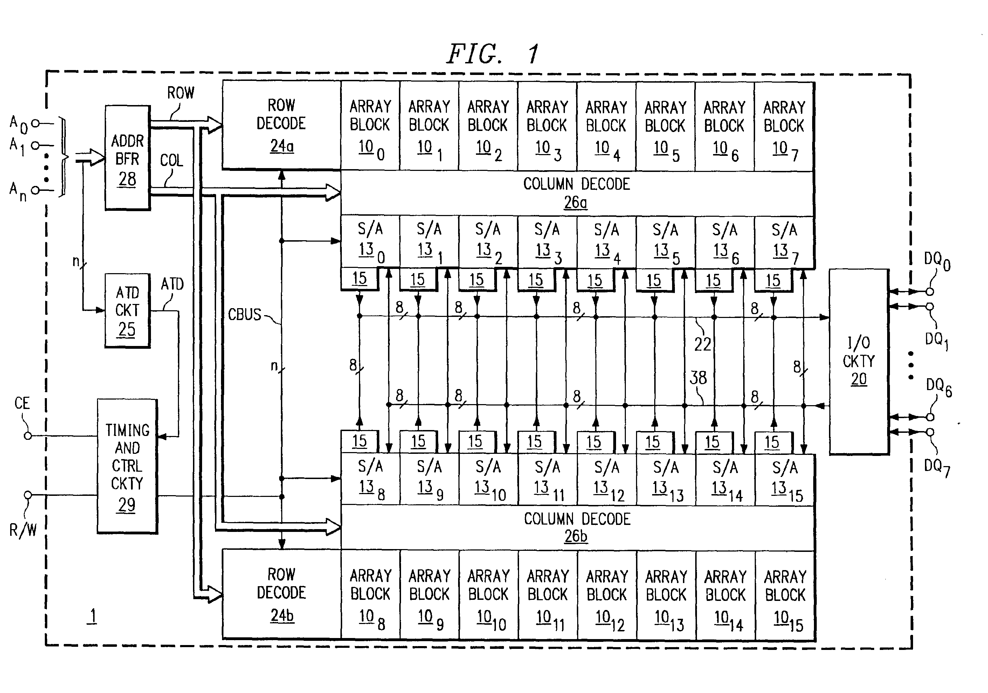

Referring now to Figure 1, an example of an integrated circuit into which the preferred embodiment of the invention is implemented will be described. In this example, memory 1 is a static random access memory (SRAM) of otherwise conventional architecture, having its memory cells in multiple blocks 10 which are shown, in Figure 1, according to an example of their physical location in such a memory. It is contemplated that integrated circuits of other types which utilize long data conductors may also benefit from the present invention, such integrated circuits including microprocessors, logic devices, and other types of memories including read-only memories, FIFOs, DRAMs and the like.

As is conventional, memory cells in memory 1 are arranged in rows and columns, and are selected according to an address signal received at address ter- minalsAₒ through An. Address terminals Aₒ through An are connected to address buffers 28, which bufferthe received address signal and communicate a portion of the address signal to row decoders 24a, 24b on bus ROW, and communicate the remainder to column decoders 26a, 26b on bus COL. Row decoders 24a, 24b select a row of memory cells by enabling the selected word line, in the conventional manner, and are thus preferably located along a side of the memory array blocks 10. Column decoders 26a, 26b, in this example, select eight memory cells in the selected row to be sensed by a sense amplifier 13 according to the column portion of the address.

In memory 1 according to this example, the memory cells are grouped into sixteen array blocks 10₀ through 10₁₅. This partitioning of the memory into sixteen array blocks 10 is particularly beneficial in low power memories, such as may be used in portable computers, as only the block 10 in which the selected memory cells are located need be enabled during a cycle. Selection of the block may be done according to one of the row address bits (indicating upper or lower half) and to four of the column address bits (indicating one of sixteen array blocks 10 to be selected). Further reduction in the active power may be obtained by the implementation of latched row line repeaters between array blocks 10, as described in copending application S.N. 588,609, filed September 26, 1990, assigned to SGS-Thomson Microelectronics, Inc., and incorporated herein by this reference.

Memory 1, as in the case of most modern SRAMs and DRAMS, includes some amount of dynamic operation, such as precharging and equilibration of certain nodes (e.g., bit lines) at particular points in the memory cycle. Initiation of the cycle in SRAM 1 occurs by way of address transition detection, performed by address transition detection (ATD) circuit 25. ATD circuit 25 is connected to each of the address inputs Aₒ through An, preferably prior to address buffers 28 (as shown), and generates a pulse on line ATD responsive to detecting a transition at any one or more of address inputs Aₒ through An, such a pulse useful in controlling the internal operation of memory 1 in the conventional manner, and also in the manner to be described hereinbelow.

Other internal operational functions are controlled by timing and control circuitry 29, which receives the signal on line ATD from ATD circuit 25, and which also receives certain external control signals such as the chip enable signal at terminal CE, and the read/write select signal at terminal R/W_. Timing and control circuitry 29 generates various control signals based on these inputs, for control of the various functions within memory 1 in the conventional manner. As shown in Figure 1, control bus CBUS is connected to sense/write circuits 13, by which such signals as the SAEQC, SCLK, ISO, and WDE signals described hereinbelow are generated and communicated within memory 1.

Memory 1 in this example is of the byte-wide type, and as such it has eight input/output terminals DQₒ through DQ₇ at which output data is presented during a read operation, and at which input data is received during a write operation. Input/output circuitry 20 is connected between output data bus 22 and input data bus 38, on the one hand, and terminals DQ, on the other hand, and includes conventional input and output buffers connected thereto. A preferred type of output buffer is described in copending application S.N. , (Attorney's Docket No. 91-C-110), filed contemporaneously herewith, assigned to SGS-Thomson Microelectronics, Inc., and incorporated herein by this reference.

Each of array blocks 10ₒ through 10₁₅ is associated with a corresponding group of sense/write circuits 13ₒ through 13₁₅, as shown in Figure 1. In this example, eight individual sense/write circuits are included within each group of sense/write circuits 13₀ through 13₁₅, one for each of the eight bits to be communicated on internal data bus 22 from the selected one of array blocks 10ₒ through 10₁₅. Each of sense/write circuits 13 include both a sense amplifier and a write driver, as will be explained in further detail hereinbelow. Groups of data drivers 15 are each associated with a corresponding group of sense amplifiers 13ₒ through 13₁₅ for receiving the data signal therefrom and for driving internal data bus 22 therewith; individual data drivers 15 are associated with individual sense/write circuits 13 in each group, one data driver 15 for driving each line in data bus 22. It is preferred that data drivers 15 have a high-impedance mode, to avoid bus conflict and to allow precharge, as described in copending application S.N. , (Attorney's Docket No. 91-C-111), filed contemporaneously herewith, assigned to SGS-Thomson Microelectronics, Inc., and incorporated herein by this reference.

In this example, the memory array is also divided into halves, with array blocks 10ₒ through 10₇ in one array half and array blocks 10₈ through 10₁₅ in the other half. Internal data bus 22 runs the length of the array halves, and is located therebetween as shown in Figure 1. Each individual data conductor in data bus 22 is connected to a corresponding data driver in each of the sixteen data driver groups 15 of the sixteen array blocks 10ₒ through 10₁₅. For a read/write memory such as memory 1, input data bus 38 is also connected to each of sense/write circuits 13, for communicating input data, from terminals DQ via input/output circuitry 20 to be written to the selected memory cells in the conventional manner. Alternatively, the input data may also be communicated in time-multiplexed fashion along data bus 22, as is conventional for some memory designs.

For purposes of fast read access times, it may be preferred to also include, within data bus 22, one dummy data conductor associated with each of the data conductors, in the manner described in the above-referenced copending application S.N. , (Attorney's Docket No. 91-C-111). As described therein, each dummy data conductor is driven to a complementary state relative to its associated data conductor, such that precharging of the data conductors in data bus 22 can be accomplished by way of charge sharing between the two.

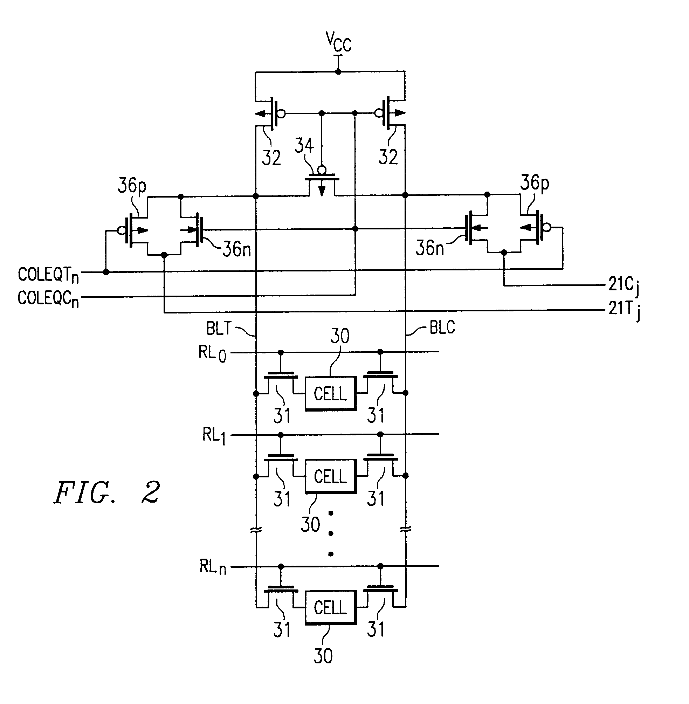

Referring now to Figure 2, the construction of a column in a an array block 10 of memory 1 will be described. This construction and its operation is described in more detail in copending application S.N. 627,059, filed December 3, 1990, assigned to SGS-Thomson Microelectronics, Inc., and incorporated herein by this reference. Memory cells 30, shown in block form in Figure 2, are in this embodiment conventional static RAM cells, constructed for example of cross-coupled n-channel inverters with resistor loads. Each cell is coupled to true and complement bit lines BLT and BLC (T and C indicating true and complement, respectively) via n-channel pass transistors 31. The gates of pass transistors 31 are controlled by row lines RL energized by the appropriate row decoder 24a, 24b; as is conventional for memory circuits, only one memory cell 30 is coupled to each pair of bit lines BLT, BLC by the operation of a row line RL.

Bit lines BLT, BLC are each connected to the drain of a p-channel transistor 32; the sources of transistors 32 are connected to a precharge voltage, which in this case is V_{cc}. In this embodiment of the invention, the gates of transistors 32 are controlled by line COLEQCₙ from its associated column decoder 26a, 26b. Transistors 32 thus precharge bit lines BLT, BLC when line COLEQCₙ from column decoder 26 is at a low logic level, indicating that the column is not selected. P-channel equilibration transistor 34 has its source-to-drain path connected between bit lines BLT, BLC, and its gate connected to line COLEQCₙ from column decoder 26, so that during such time as line COLEQCₙ is low (i.e., during precharge via transistors 32), bit lines BLT, BLC are equilibrated to the same potential, which in this case is V_{cc}.

As described in the above-incorporated copending application S.N. 627,059, the signal on line COLEQCₙ which enables precharge and equilibration of column n in memory 1 is decoded from the column address value (i.e., it is the logical complement of select line COLEQTₙ). Therefore, during such time as column n is not selected, its bit lines BLT, BLC are being precharged and equilibrated to one another. For memory 1 of Figure 1, this means that all columns in array blocks 10 which do not contain the selected columns, and all non-selected columns in the selected array block 10 (in this case, all but eight columns) are in their precharge and equilibration state. The advantages of this decoded precharge and equilibrate control are described in detail in the above-referenced copending application S.N. 627,059, and generally include reduction in the active current drawn for precharge and equilibration since only selected columns need be precharged and equilibrated. In addition, the transients generated within memory 1 are much reduced, since the instantaneous current required to effect precharge and equilibration is significantly reduced. Such construction also eliminates the need for a static or other load on the bit lines to provide a pull-up for unselected columns which are not released, thus allowing the selected memory cell 30, or write circuit, to establish a differential signal on floating bit lines BLT and BLC without opposing a pull-up or other DC load connected thereto.

Alternatively, the gates of precharge transistors 32 and equilibration transistor 34 may be controlled by global timing signals from timing and control circuitry 29, such that all columns are equilibrated and precharged simultaneously, and so that all columns are also released in each access so that the contents of the selected memory cell 30 in the selected row will develop across bit lines BLT, BLC, regardless of whether or notthe column is selected. Such operation occurs in conventional dynamic RAMs, so that refresh of non-selected columns is accomplished. Memories according to this alternative arrangement may also obtain the benefits of the present invention.

Each of bit lines BLT, BLC are also connected to pass gates 36, each pass gate 36 including a p-channel transistor 36p and an n-channel transistor 36n having their source-to-drain paths connected in parallel. Input/output lines 21Tⱼ, 21Cⱼ (true and complement, respectively) are connected on the other sides of pass gates 36 from bit lines BLT, BLC, respectively. The gates of transistors 36n are connected to line COLEQCₙ and the gates of transistors 36p are connected to line COLEQTₙ; accordingly, transistors 36n and 36p for a column are on when the column is selected (line COLEQCₙ being high and line COLEQTₙ being low), and transistors 36n and 36p for a column are off when the column is not selected (line COLEQCₙ being low and line COLEQTₙ being high). Pass gates 36 thus communicate the state of bit lines BLT and BLC to input/output lines 21Tⱼ and 21Cⱼ, respectively, when the column is selected as indicated on lines COLEQCₙ and COLEQTₙ. The column of Figure 2 is associated with thejth of sense/write circuits 13, as indicated by input/output lines 21Tⱼ and 21Cⱼ. It should be noted that each of the columns in array block 10ₙ which are associated with thejth sense amplifier 13 will also have their pass gates 36 connected to input/output lines 21Tⱼ and 21Cⱼ; since only one of these columns will be selected by column decoder 18 for a given column address value, there will be no bus conflict on input/output lines 21 Tⱼ and 21 Cⱼ, as the unselected columns will have their pass gates 36 in the off state.

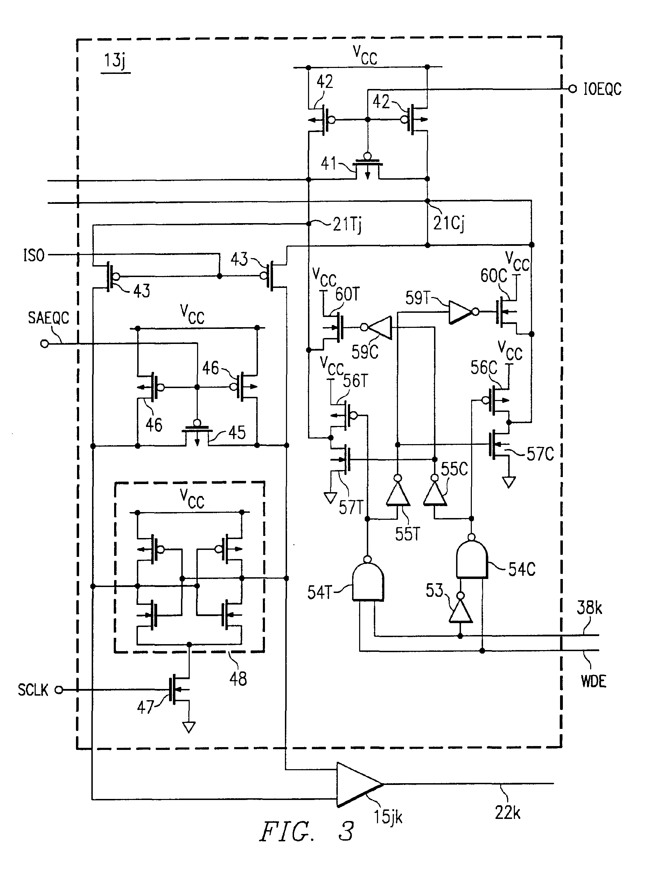

Referring now to Figure 3, the construction of one example of sense/write circuit 13, including both read and write paths, will now be described. It is of course contemplated that other designs and arrangements of sense amplifiers and write circuitry may also be used in conjunction with the present invention. Specifically, one example of such an alternative design is a multiple stage sense amplifier scheme, including a level shifter stage connected to each of the differential bit lines for implementing a DC level shift thereon, followed by a combination of a current mirror and differential sense amplifier (the differential sense amplifier similar as that shown in Figure 3). Other sense amplifier configurations and implementations may similarly be used, in the alternative to that shown in Figure 3.

In Figure 3, complementary input/output lines 21Tⱼ and 21C are each connected to the drain of a p-channel precharge transistor 42; the sources of transistors 42 are both connected to the precharge voltage for the input/output lines 21Tⱼ, 21Cj, which in this case is V_{cc}. Input/output lines 21Tⱼ and 21Cⱼ are also connected to one another by p-channel equilibration transistor 41. The gates of transistors 41 and 42 are connected to line IOEQC, which is generated by timing and control circuitry 29 responsive to an address transition detected by ATD circuit 25, or to such other events during the cycle for which equilibration of input/output lines 21 are desired.

On the read side of sense/write circuit 13ⱼ, input/output lines 21Tⱼ, 21C are each connected to a p-channel pass transistor 43, each of pass transistors 43 having its gate controlled by an isolate signal ISO. Accordingly, input/output lines 21Tⱼ and 21Cⱼ may be isolated from the read circuitry by line ISO at a high logic level, and may be connected thereto by line ISO at a low logic level. The complementary lines on the opposite side of pass transistors 43 from true and complement input/output lines 21Tⱼ and 21Cⱼ are referred to in Figure 3 as true and complement sense nodes SNT and SNC, respectively.

Sense nodes SNT, SNC are also preferably precharged and equilibrated during the appropriate portion of the cycle, as sense amplifier 48 within sense/write circuit 13 operates in dynamic fashion, as will be described hereinbelow. P-channel precharge transistors 46 each have their source-to-drain paths connected between V_{cc} and sense nodes SNT, SNC, respectively. Equilibration transistor 45 is a p-channel transistor having its source-to-drain path connected between sense nodes SNT, SNC. The gates of transistors 45 and 46 are all controlled by line SAEQC which, when at a low level, precharges and equilibrates sense nodes SNT, SNC in similar manner as described above relative to bit lines BLT, BLC and input/output lines 21Tj, 21 Cⱼ.

Sense amplifier48 is a conventional CMOS latch consisting of cross-coupled inverters therewithin; the inputs and outputs of the cross-coupled latches are connected to sense nodes SNT, SNC in the conventional manner. N-channel pull-down transistor 47 has its source-to-drain path connected between the sources of the n-channel transistors in sense amplifier 48 and ground, and has its gate controlled by line SCLK.

Pull-down transistor 47 provides dynamic control of sense amplifier 48, so that the sensing of sense nodes SNT, SNC is performed in dynamic fashion. As is well known in dynamic RAMs, the dynamic sensing in this arrangement is controlled with transistor47 initially off at the time that pass transistors 43 connect sense nodes SNT, SNC to input/output lines 21Tⱼ and 21Cⱼ; during this portion of the cycle, sense amplifier 48 is presented with a small differential voltage between sense nodes SNT, SNC. After development of this small differential voltage, line SCLK is driven high, so that the sources of the pull-down transistors in sense amplifier 48 are pulled to ground. This causes sense amplifier 48 to develop a large differential signal on sense nodes SNT, SNC, and latch the sensed state of sense nodes SNT, SNC.

In this example, sense amplifier 13ⱼ is associated with input/output terminal DQₖ. Accordingly, sense nodes SNT, SNC are coupled to the inputs of tristate data driver 15ⱼₖ, which drives data bus conductor 22ₖ which is in communication with input/output circuitry 20. In a read operation, input/output circuitry 20 will include the appropriate output drivers, such as the one described in the above-noted copending application S.N. , (Attorney's Docket No. 91 -C-110), for presenting the state of data bus conductor 22ₖ at input/output terminal DQₖ.

Looking now to the write side of sense/write circuit 13ⱼ, line 38ₖ of input bus 38 communicates input data from input/output terminal DQₖ via input/output circuitry 20, in a write operation. Write control signal WDE from timing and control circuitry 29, and input data line 38ₖ, are received by the inputs to NAND gates 54T and 54C (with line 38, inverted by inverter 53 prior to its connection to NAND gate 54C). According to the present invention, write control signal WDE is generated according to the timing of the equilibration signals (e.g., lines COLEQC, IOEQC) together with a write enable received at terminal R/W_. The generation of write control signal WDE, and the advantages of the present invention in such generation, will be described hereinbelow.

The output of NAND gate 54T controls the gate of a p-channel pull-up transistor 56T connected in push-pull fashion with an n-channel pull-down transistor 57T; the output of NAND gate 54T is also connected, via inverter 55T, to the gate of an n-channel pull-down transistor 57C which is connected in push-pull fashion with p-channel pull-up transistor 56C. Similarly, the output of NAND gate 54C is connected directly to the gate of pull-up transistor 56C, and is connected via inverter 55C to the gate of pull-down transistor 57T. The drains of transistors 56T and 57T drive input/output line 21Tⱼ, and the drains of transistor 56C and 57C drive input/output line 21 Cⱼ.

Accordingly, the write side of sense/write circuit 13ⱼ operates as a complementary pair of tri-state drivers. The drivers present a high-impedance state to input/output lines 21Tj, 21 Cⱼ responsive to write control line WDE being at a low logic level, as this places the outputs of both of NAND gates 54T and 54C at a high logic level, turning off all of transistors 56T, 56C, 57T, and 57C. Write control line WDE is, of course, at such a low logic level during read cycles, and during write cycles to array blocks 10 other than the one associated with sense/write circuit 13ⱼ.

According to this preferred embodiment, source followers are also provided on the write side of sense/write circuit 13ⱼ. N-channel transistor 60T has its source connected to input/output line 21 Tⱼ and has its drain biased to Vcc; the gate of transistor 60T is controlled by the output of NAND gate 54C, inverted twice by inverters 55C and 59C. Similarly, n-channel transistor 60C has its source connected to input/output line 21 C, and has its drain biased to Vcc; the gate of transistor 60T is controlled by the output of NAND gate 54T, inverted twice by inverters 55T and 59T.

The source followers of transistors 60T and 60C are provided in order to assist in the pull up of input/output lines 21 Tⱼ and 21 Cⱼ after a write operation and before a read operation (often referred to as "write recovery"). In operation, during a write operation, the one of input/output lines 21Tⱼ and 21Cⱼ that is driven to a low level by pull-down transistor 57 will also have its associated source follower transistor 60 off (due to the inversion from inverter 59); source follower transistor 60 will be on for the other input/output line which is driven high by its pull-up device 56. Upon write control line WDE returning to a low logic level at the end of the write operation, the outputs of both of NAND gates 54 will be high, and accordingly the transistor 60 which was not previously on will be turned on. This will pull up its associated input/output line 21 j from its prior low level toward the voltage V_{cc-}Vₜ (Vₜ being the threshold voltage of transistor 60). Precharge transistors 42, once turned on, will pull up input/output lines 21Tⱼ and 21Cⱼ fully to V_{cc}; once the voltages of input/output lines 21Tⱼ and 21Cⱼ reach a voltage above V_{cc-}Vₜ, transistors 60 will have no further effect. Source follower transistors 60 thus assist the write recovery of memory 1, without requiring critical timing control, and in a manner with reduced di/dt noise. Furthermore, since both source follower transistors 60 are on during read operations, input/output lines 21Tⱼ and 21Cⱼ are advantageously clamped to V_{cc-}Vₜ, allowing for easy development of differential voltage thereon.

While the write circuitry described in sense/write circuit 13ⱼ is particularly advantageous for the reasons noted above, and as described in the above-referenced copending application S.N. 627,059, this circuitry is described by way of example only. It is to be understood that other conventional write circuits which have their operation controlled by a signal such as that described above on line WDE can be used with the present invention, and obtain the full benefit thereof.

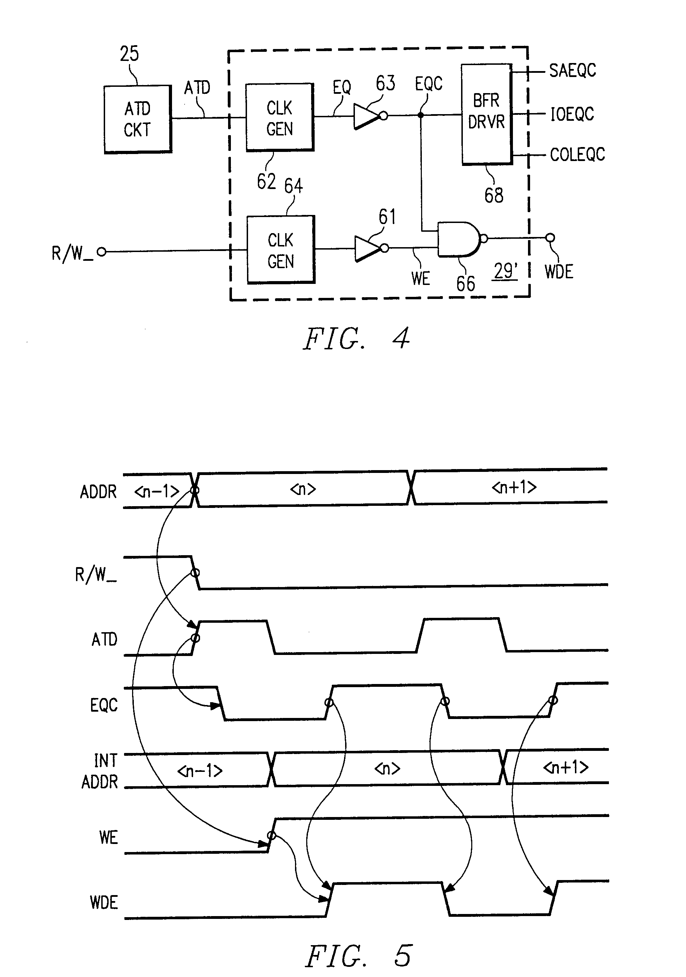

Referring now to Figure 4, control circuit 29' in timing and control circuitry 29 will now be described in detail; the function of control circuit 29' is to generate the equilibration signals SAEQC, IOEQC, COLEQC, discussed above, as well as others useful in both read and write operations in memory 1. In addition, control circuit 29' also is for generating write control signal WDE received by the write circuit in each of sense/write circuits 13 in memory 1. The generating of write control signal WDE according to the present invention is particularly advantageous in achieving high performance write operations, with limited risk of race conditions and other errors in such operations.

Control circuit 29' receives a first input from read/write terminal R/W_ (buffered if desired in the conventional manner, not shown), which indicates with a high level that a read operation is to be performed and which indicates with a low level that a write operation is to be performed. Read/write terminal R/W_ is coupled, via clock generator 64 and inverter 61 (on line WE), to a first input of AND gate 66; the output of AND gate 66 drives line WDE with the write control signal described hereinabove. Clock generator circuit 64 may be constructed in the conventional manner to generate an internal clock signal responsive to the pulse on lineATD, this internal clock signal having the desired delay from the ATD pulse and duration (which may be different from that of the ATD pulse) to effect the equilibration operations in memory 1. While the present invention does not rely on delays within clock generator 64 for proper signal generation, delays can be utilized therein for optimization of the circuit performance.

Control circuit 29' also receives line ATD from ATD circuit 25; a positive polarity pulse appears on line ATD responsive to the detection of a transition at one of the address inputs (or control signal inputs, if desired), and thus at the beginning of a new memory cycle. Clock generator 62 receives line ATD and generates signals EQ which is applied to inverter 63, the output of which drives line EQC. As in the case of clock generator 64, clock generator 62 is constructed in the conventional manner to generate a clock signal of the desired timing and duration responsive to terminal R/W_ , and may include designed-in delays for optimization of the performance of memory 1. Line EQC is applied to a second input of AND gate 66. Line EQC is also received by various buffers or drivers 68, which each generate the specific equilibration signals applied to the columns and sense/write circuits 13 as described hereinabove. In this embodiment of the invention, line EQC is low during equilibration for all columns, and high when equilibration is not enabled.

Line WDE thus corresponds to the logical AND of lines WE and EQC. As described hereinabove, line WDE operates, when at a high logic level, to enable the writing of data from input data bus 38 to the selected memory cell via input/output lines 21T, 21C. Referring again to Figure 4, it is evident that, in this embodiment of the invention, line WDE is only at a high logic level when both line WE is high (indicating a write signal received at terminal R/W_ ) and line EQC high (indicating that the equilibration portion of the cycle is not occurring). Accordingly, the write circuitry in sense/write circuits 13 is enabled only during non-equilibration portions of the cycle. As will be described hereinbelow, such gating of the write enable signal on line WDE to correspond to equilibration ensures proper operation of write operations in memory 1, even at high speeds.

Referring now to Figure 5, the operation of memory 1 according to the present invention will now be described, for the examples of write operations to arbitrary memory cells 30 having address values n and n+1. The example begins from a prior cycle, in which a read operation to memory cell 30 specified by the address n-1 was being performed. Accordingly, both address terminaisAothrough An (shown on lineADDR in Figure 5) and the internal decoded address value (shown on line INTADDR in Figure 5) are carrying the value n-1, and terminal R/W_ is at a high logic level.

The next cycle begins with a new address value, in this case the value n, being received at address ter- minalsAₒ through An; a low logic level is also received at terminal R/W- at this time, in this example, indicating that a write operation is to be performed. In response to the transition at one or more of address ter- minalsAₒ through An and also at terminal R/W_, ATD circuit 25 generates a high logic level pulse on line ATD. This high level pulse on line ATD is received by control circuit 29' (Figure 4), which generates a low logic level pulse on line EQC responsive thereto. As described hereinabove, the low logic level pulse on line EQC initiates the precharge and equilibration operations via buffer drivers 68 issuing active low pulses on lines IOEQC and SAEQC (both to sense/write circuits 13), and low and high pulses on lines COLEQC, COLEQT, respectively (to all bit lines).

During the equilibration period, shown in Figure 5 as the time during which line EQC is low, address decoding and other internal operations may take place within memory 1 in preparation of the desired access. As shown in Figure 5, the internal decoded addresses reach the new value corresponding to address value n; in addition, clock generator 64 generates a high logic level on line WE.

In prior conventional memories, the signal on line WE (or a similar signal) generated from terminal R/W_ would be coupled to control the write circuitry in the sense/write circuits. The timing of this signal relative to the decoding of the addresses would be critical, however, because if it were generated prior to the settling of the internal address value, data would be written to the memory cell corresponding to the prior address value (address n-1 in this case) as well as to the desired address. The memory array would thus store incorrect information.

In this embodimentof the invention, however, line WE is not directly coupled to the write circuitry in sense/write circuits 13, but instead is presented to an input of AND gate 66 in control circuit 29', which receives line EQC at its other input, and which drives line WDE at its output. As a result, line WDE is not driven high, and does not enable the write circuitry, until the equilibration operation is complete, as indicated by line EQC being driven to a high logic level. Since the equilibration period will continue if address transitions continue to be detected, signals on line EQC being generated from the ATD pulses, the internal decoded address value will have settled by the time equilibration is complete. As a result, the timing of line WE relative to the decoding of the internal address values is no longer critical.

Furthermore, particularly in extremely long memory chips, conventional memory design required consideration of the write operation in the design of the timing paths for internal address propagation and signals such as the ATD pulses. In particular, if the timing of such signals were optimized solely for read performance in such memories, the internal address signals may reach the memory location prior to the termination of a write operation, causing a write error thereat. This required the design of the timing of these signals to tradeoff read performance with the write timing of the memory. According to the present invention, however, the interlock of the internal write signal with the equilibration timing allows the design of the timing of the internal read signals (e.g., address propagation) to be optimized solely for read access time performance, without subjecting the memory to the risk of write termination errors.

Upon line WDE going to a high level, the write circuitry in the selected sense/write circuit 13ⱼ is operable to present the data on its associated input data bus conductor 38ₖ to input/output lines 21 Tⱼ, 21 Cⱼ, to be written into the selected memory cell 30 corresponding to the selected column and row. Line WDE can continue to be driven high until the next cycle (as shown), or alternatively can be timed out to reduce power dissipation.

Upon receipt of the next address value n+1, ATD circuit 25 will again issue a high level pulse on line ATD, which will again cause line EQC to be driven low as described above to effect the equilibration operation. As line EQC goes low, line WDE is driven low by the operation of AND gate 68, despite the low logic level signal remaining at terminal R/W_. This equilibration operation occurs, in memory 1 as in conventional memories, well prior to the decoding of the address value. As such, the write operation is safely terminated before the internal receipt of the new address value, precluding the erroneous writing of the prior cycle input data into the next cycle's address. As in the prior cycle, line WDE is driven high upon completion of equilibration, as caused by line EQC returning high.

According to the present invention, therefore, where the write enable signal communicated to the write circuitry is interlocked with the equilibration signals, high performance write operations can be accomplished with minimal risk of writing to the wrong location. The write enable signal can begin no earlier than the completion of equilibration, which depends upon the settling of the addresses, thus guaranteeing that data will not be written to the memory location accessed in the prior cycle. In addition, the write enable signal is terminated at the beginning of equilibration in the next cycle, thus assuring that the prior cycle's data is not written to the next cycle's address. Such control is obtained without relying on relative delay periods, and thus with minimal risk of race conditions, especially for high speed, large chip size, integrated circuit memories.

While the invention has been described herein relative to its preferred embodiments, it is of course contemplated that modifications of, and alternatives to, these embodiments, such modifications and alternatives obtaining the advantages and benefits of this invention, will be apparent to those of ordinary skill in the art having reference to this specification and its drawings. It is contemplated that such modifications and alternatives are within the scope of this invention as subsequently claimed herein.

## Claims

1. Aread/write memory in an integrated circuit, comprising:
a plurality of memory cells;
a decoder for selecting a memory cell according to an address value;
an input data terminal for receiving data to be written into a selected memory cell;
a read/write terminal for receiving a write select signal;
differential data lines, for communication of data to said memory cells;
an equilibration transistor coupled between said differential data lines, and having a control terminal for receiving an equilibration signal;
a sense/write circuit for communicating data from said input data terminal to said selected memory cell by way of said differential data lines, said sense/write circuit having a control terminal for receiving a write enable signal;
an equilibration control circuit for generating said equilibration signal responsive to an external signal indicating the initiation of a memory cycle; and
a write control circuit for generating said write enable signal responsive to said write select signal and responsive to said equilibration signal.

2. The memory of claim 1, wherein said plurality of memory cells are arranged in rows and columns;
and wherein said differential data lines comprise:
a pair of bit lines associated with each of said columns, and having an equilibration transistor connected therebetween.

3. The memory of claim 2, further comprising:
a sense amplifier for sensing, in a read operation, a differential signal from the bit lines associated with the column containing the selected memory cell;
and wherein said differential data lines further comprise:
a pair of differential input/output lines connected to said sense amplifier, for presenting a differential signal corresponding to the sensed differential signal from the bit lines; and
a sense amplifier equilibration transistor connected between said differential input/output lines, and having a control terminal coupled to receive said equilibration signal.

4. The memory of claim 1, further comprising:
a sense amplifier for sensing, in a read operation, a differential signal from the bit lines associated with the column containing the selected memory cell;
and wherein said differential data lines comprise:
a pair of differential input/output lines connected to said sense amplifier, for presenting a differential signal corresponding to the data state of the selected memory cell; and
a sense amplifier equilibration transistor connected between said differential input/output lines, and having a control terminal coupled to receive said equilibration signal.

5. The memory of claim 1, wherein said write control circuit disables said write enable signal during the time that said equilibration signal is active.

6. The memory of claim 1, wherein said write control circuit disables said write enable signal during read operations.

7. The memory of claim 1, further comprising:
address terminals for receiving said address value.

8. The memory of claim 7, wherein said external signal comprises a change in the address value received at said address terminals.

9. The memory of claim 1, further comprising:
a precharge transistor, connected to one of said differential data lines, and having a control terminal coupled to receive said equilibration signal, for precharging said differential data lines to a selected voltage responsive to said equilibration signal.

10. Amethod for operating a read/write memory, said memory comprising a plurality of addressable memory cells and a sense/write circuit for communicating data from an input data terminal to a selected memory cell by way of differential data lines, comprising the steps of:
responsive to receiving an external signal indicating initiation of a memory access, equilibrating said differential data lines for a selected duration;
during said equilibrating step, decoding an address value for selecting a memory cell in said plurality;
responsive to receiving a write signal and to the end of the duration of the equilibrating step, enabling said sense/write circuit to communicate input data to the memory cell selected by said decoding step.

11. The method of claim 10, further comprising:
after the beginning of said enabling step and responsive to receiving an external signal indicating initiation of a second memory access, disabling said sense/write circuit.

12. The method of claim 11, further comprising:
after the beginning of said enabling step and responsive to receiving an external signal indicating initiation of a second memory access, equilibrating said differential data lines for a selected duration;
wherein said disabling step is responsive to said equilibrating step responsive to receipt of the external signal indicating initiation of the second memory access.

13. The method of claim 10, further comprising:
monitoring address terminals of said memory to detect transitions thereat;
wherein said external signal comprises detection of a transition at one of said address terminals.

14. The method of claim 10, wherein said plurality of memory cells are arranged in rows and columns;
and wherein said differential data lines comprise:
a pair of bit lines associated with each of said columns of said plurality of memory cells.

15. The method of claim 14, wherein said differential data lines further comprise:
a pair of input/output lines associated with said sense/write circuit.

16. The method of claim 10, wherein said differential data lines comprise:
a pair of input/output lines associated with said sense/write circuit.
